# EUROPÄISCHE PATENTSCHRIFT

(11) **EP 1 434 900 B1**
(45) Veröffentlichungstag und Bekanntmachung des Hinweises auf die Patenterteilung: **10.12.2008**
(21) Anmeldenummer: 02776774.8
(22) Anmeldetag: 01.10.2002
(51) Int. Cl.: C23C 30/00

(54) **VERWENDUNG EINER HARTSTOFFSCHICHT& x9;**
USE OF A HARD MATERIAL LAYER
UTILISATION D'UNE COUCHE DE MATIERES DURES

(30) Priorität: 01.10.2001 DE 10149397
(43) Veröffentlichungstag der Anmeldung: 07.07.2004
(73) Patentinhaber: Continental Automotive GmbH, 30165 Hannover (DE)
(72) Erfinder: KARRAS, Bernd, 10997 Berlin (DE); KRÜGER, Ursus, 14098 Berlin (DE); PYRITZ, Uwe, 13599 Berlin (DE); SCHIEWE, Heike, 12167 Berlin (DE)
(86) Internationale Anmeldenummer: PCT/DE2002/003743
(87) Internationale Veröffentlichungsnummer: WO 2003/031685

(56) Entgegenhaltungen:
- EP-A- 0 798 572
- DD-A- 131 184
- DE-A- 19 944 977
- US-A- 5 458 928
- COLLARD, S. ET AL: "Growth of nitrogen stabilised cubic ZrO2 phase by reactive magnetron sputtering using two reactive gases" VACUUM (1999), 55(2), 153-157 , 1999, XP002236014
- ENSINGER, W. ET AL: "Ion-beam assisted coating of tube inner walls by plasma immersion ion implantation" SURFACE AND COATINGS TECHNOLOGY (2000), 128-129, 270-273 , 2000, XP002236015

## Beschreibung

Die Erfindung betrifft die Verwendung einer Hartstoffschicht mit vergleichsweise geringem Reibungswiderstand.

Derartige Hartstoffschichten sind in der deutschen Patentschrift DE 44 18 517 C1 angegeben. Gemäß diesem Dokument kann auf abrasiv beanspruchte Oberflächen eine aus Hartstoffen bestehende Verschleißschutzschicht aufgebracht werden, welche aufgrund ihrer Härte zur Erhöhung der Verschleißbeständigkeit beiträgt.

Allerdings weist gemäß DE 44 18 517 C1 die Verschleißschutzschicht einen relativ hohen Reibungswiderstand auf. Dieser kann verringert werden, indem die gebildete Verschleißschutzschicht in einem weiteren Prozessschritt mittels geeigneter Schmierstoffe im Vakuum unter Druckbeaufschlagung imprägniert wird. Dabei werden in die Hartstoffschicht beispielsweise hochtemperaturfeste anorganische Schmierstoffe eingebracht, die den Reibungswiderstand der Oberfläche der Hartstoffschicht vermindern.

Gemäß der deutschen Patentanmeldung DE 199 44 977 A1 wird z. B. zur Erreichung einer geforderten Lebensdauer vorgeschlagen, auf relativ zueinander bewegliche Ventilteile von Kraftstoffeinspritzventilen, Beschichtungen aus Chromnitrid oder aus kohlenstoffhaltigem Wolframcarbid aufzubringen, wodurch die Verschleißbeständigkeit erhöht werden kann.

Die Aufgabe der Erfindung liegt in der Bereitstellung eines Kraftstoffeinspritzventils, welches eine vergleichsweise verlängerte Lebensdauer aufweist.

Die Lösung der Aufgabe wird dadurch erreicht, dass als Hartstoffschicht für zumindest eines von zwei sich berührenden, relativ zueinander beweglichen Ventilteilen in einem Einspritzventil für den Kraftstoff einer Brennkraftmaschine eine Zirkonoxinitridschicht mit einer aus Zirkon, Stickstoff und Sauerstoff enthaltenden, insbesondere eine definierte Struktur aufweisenden Phase verwendet wird. Diese definierte Struktur kann beispielsweise eine kubische Struktur mit einem Elementarzellenparameter a zwischen 0,511 nm und 0,532 nm sein. Dadurch kann vorteilhafterweise der Verschleiß des beschichteten Bauteiles sowie auch des unbeschichteten Partners stark herabgesetzt werden. Eine weitere Verbesserung lässt sich erzielen, wenn beide sich relativ zueinander bewegenden Bauteile beschichtet werden. Durch den geförderten Kraftstoff stellt sich während der Bewegung der Bauteile ein Zustand der Mangelschmierung ein, da der Kraftstoff als solcher keine optimalen Schmiereigenschaften besitzt. Ein Zusatz zur Verbesserung der Schmiereigenschaften verbietet sich jedoch aufgrund der anschließenden Verbrennung in der Brennkraftmaschine. Daher stellt der erfindungsgemäße Schichtaufbau eine Lösung dar, die Verschleißeigenschaften der beschichteten Ventilbauteile zu verbessern. Durch die Verminderung des Verschleißes der sich relativ zueinander bewegenden Bauteile lässt sich die Lebensdauer des Einspritzventils verlängern.

Eine vorteilhafte Ausführungsform der Erfindung wird erreicht, indem bei einem Ventilsitz mit einer Ventilnadel als dem ersten Ventilteil und dem eine durch die Ventilnadel verschließbaren Einspritzöffnung aufweisenden zweiten Ventilteil zumindest die Ventilnadel mit der erfindungsgemäßen Zirkonoxinitridschicht versehen ist. Die Ventilnadel ist das am stärksten belastete Bauteil im Einspritzventil und somit als kritisch für die Lebensdauer des Ventils zu betrachten.

Als vorteilhaft ist es anzusehen, ebenfalls die Wandungen der Einspritzdüse zu beschichten. Hierdurch lässt sich die die Lebensdauererwartung des Kraftstoffeinspritzventils weiter erhöhen.

Es ist zwar aus der Dissertation "Röntgenstrukturuntersuchungen an Oxinitridschichten auf Chrom- und Zirkoniumbasis" von Stéphane Collard, die an der technischen Universität Chemnitz, Deutschland angefertigt wurde, und aus Vacuum 55 (1999) 153-157 "Growth of nitrogen stabilised cubic ZrO2 phase by reactive magnetron sputtering using two reactive gases", S. Collard et al. bekannt, Oxinitridschichten auf der Basis von Chrom und Zirkonium mit Hilfe eines reaktiven Sputterverfahrens herzustellen, unter denen sich auch eine Schicht mit einer Zirkon, Stickstoff und Sauerstoff enthaltenden Phase befindet, jedoch ist in dieser Dissernation kein Hinweis darauf enthalten, dass eine Schicht mit einer Zirkon, Stickstoff und Sauerstoff enthaltenden Phase sich nicht nur durch Härte, sondern auch durch geringen Reibwiderstand auszeichnet und daher - anders als beim eingangs behandelten Stand der Technik - in einem einzigen Prozessschicht ohne Nachbehandlung herstellbar ist.

Der Erfindung liegt die Erkenntnis zugrunde, dass die Zirkon, Stickstoff und Sauerstoff enthaltende Phase hauptverantwortlich für einen überraschend geringen Reibungswiderstand der erfindungsgemäßen Zirkonoxinitridschicht im Vergleich zu anderen Hartstoffschichten, insbesondere auch anderen Zirkonoxinitridschichten ist, die die genannte Phase nicht enthalten. Die erfindungsgemäße Zirkonoxinitridschicht muss nicht ausschließlich durch diese Phase gebildet sein, sondern die Schichtzusammensetzung kann auch Phasen aus Zirkonoxid oder Zirkonnitrid enthalten.

Die erfindungsgemäß verwendeten Schichten stellen aufgrund ihrer hohen Härte sowie ihres geringen Reibungswiderstandes einen hervorragenden Verschleißschutz für hochbeanspruchte Bauteile dar. Die Herstellung dieser Schichten kann durch Sputtern in einem Prozessschritt aufgebracht werden, wodurch die Herstellung sehr einfach ist. Insbesondere können weitere Bearbeitungsschritte zur Verringerung des Reibungswiderstandes der gebildeten Schicht, so z. B. die Imprägnierung mit einem Schmiermittel, eingespart werden. Dadurch wird ein gutes Preis-Leistungs-Verhältnis bei Verwendung des erfindungsgemäßen Zirkonoxinitridschicht bezogen auf den erreichbaren Verschleißschutz und die anfallenden Fertigungskosten erreicht.

Gemäß der Erfindung weist die Zirkon, Stickstoff und Sauerstoff enthaltende Phase der Zirkonoxinitridschicht eine kubische Kristallstruktur mit einem Elementarzellenparameter a zwischen 0.511 nm und 0,532 nm auf. Für diese definierte Kristallstruktur hat es sich gezeigt, dass der Reibungswiderstand der diese Phase enthaltenden Zirkonoxinitridschicht besonders gering ausfällt, wodurch sich diese Schicht besonders gut für den Einsatz zur Beschichtung verschleißbeanspruchter Bauteile eignet.

Die erfindungsgemäß verwendeten Zirkonoxidnitridschicht lässt sich beispielsweise mittels eines reaktiven Sputterverfahrens herstellen. Herstellungsbedingungen, die hierbei beispielsweise zur Bildung von Zirkon, Stickstoff und Sauerstoff enthaltenden, eine definierte Kristallstruktur aufweisenden Phasen in einer Zirkonoxinitridschicht führen, sind im Anhang der eingangs genannten Dissertation aufgeführt. Danach kann das reaktive Sputtern unter Benutzung eines Zirkontargets durchgeführt werden, wobei ein Abstand zwischen Target und zu beschichtendem Substrat von 6.5 cm gewählt wird. Die Herstellungstemperatur liegt bei 400°C wobei ein Entladungsstrom von 1,5 A eingehalten wird. Dem Sputterverfahren wird Stickstoff und Sauerstoff zugeführt, wobei der Stickstofffluss bei 2,8 sccm (Standard Kubikzentimeter pro Minute) eingestellt wird und der Sauerstofffluss zwischen 0.25 und 2 sccm variiert werden kann. Während bei kleinen und großen Sauerstoffflüssen lediglich die Bildung von Zirkonoxidnitridschichten mit Zirkon und Stickstoff bzw. mit Zirkon und Sauerstoff enthaltenden Phasen zu beobachten ist, können die erfindungsgemäßen Zirkonoxidnitridschichten mit einer Zirkon, Stickstoff und Sauerstoff enthaltenden, insbesondere eine definierte Kristallstruktur aufweisenden Phase bei mittleren Sauerstoffflüssen hergestellt werden. Es ist beispielsweise bei Sauerstoffflüssen zwischen 0,5 und 1 sccm auch die Bildung einer solchen Phase mit kubischer Struktur und einem Elementarzellenparameter a zwischen 0.511 nm und 0,532 nm möglich. Der Stickstoffanteil kann in der Zirkon, Stickstoff und Sauerstoff enthaltenden, eine definierte Struktur aufweisenden Phase zwischen 30 und 44 Atomprozent und der Sauerstoffanteil zwischen 18 und 39 Atomprozent betragen.

Weitere Einzelheiten der Erfindung lassen sich der Zeichnung entnehmen, wobei diese keine Beschränkung der beanspruchten Erfindung darstellen.

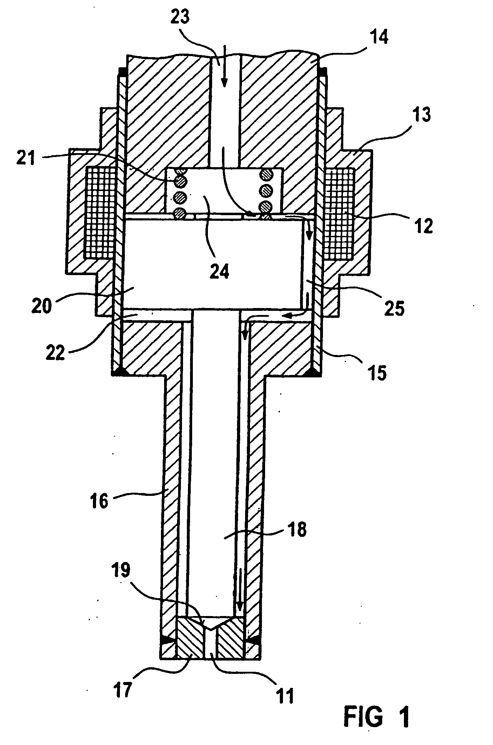

Es zeigt
- Figur 1: schematisch ein Ausführungsbeispiel eines Einspritzventils für den Kraftstoff einer Brennkraftmaschine im Mittelschnitt.

In Figur 1 ist ein Brennstoffeinspritzventil dargestellt, welches in einen nicht dargestellten Zylinderkopf eingebaut werden kann, derart, dass es mit einer Einspritzöffnung 11 in den ebenfalls nicht dargestellten Brennraum des Zylinders mündet. Das Brennstoffeinspritzventil umfasst als Aktor weiterhin eine Magnetspule 12, die in einem Spulengehäuse 13 gekapselt ist, einen rohrförmigen Innenpol 14 und einen hülsenförmigen Außenpol 15, welcher in einen Düsenkörper 16 mündet.

In den Düsenkörper 16 ist ein Ventilsitzkörper 17 eingebracht, der die Einspritzöffnung 11 bildet. Der Verschluss des Ventils wird über eine Ventilnadel 18 erreicht, welche die Einspritzöffnung 11 mittels einer Sitzfläche 19 verschließen und öffnen kann. Hierzu ist die Ventilnadel an einem Anker 20 befestigt, welcher entgegen einer durch eine Feder 21 ausgeübten Schließkraft durch die Magnetspule 12 vom Ventilsitz hin zu einer Offenstellung wegbewegt werden kann (nicht dargestellt). In der Offenstellung kann der Kraftstoff entsprechend der angedeuteten Pfeile durch ein Kanalsystem 22 geleitet werden, wobei dieses durch eine Zuführbohrung 23 einen Einbauraum 24 für die Feder 21, eine Nut 25 im Anker 20 und den Düsenkörper 2 der Einspritzöffnung 11 zugeführt wird.

Zur Verbesserung des Verschleißwiderstandes ist die Ventilnadel 18 und der Ventilsitzkörper 17 mit einer Zirkonoxinitridschicht versehen, welche eine Zirkon, Stickstoff und Sauerstoff enthaltende, eine definierte Struktur aufweisende Phase aufweist (nicht näher dargestellt). Diese beiden Teile können als Einzelteile beschichtet und erst anschließend an den zugehörigen Bauteilen des Einspritzventils befestigt werden. Von besonderer Bedeutung ist die Schicht im Bereich der hochbelasteten Ventilsitzfläche 19, wobei in diesem Bereich durch eine entsprechende Positionierung der Bauteile in der Sputterdiode besonders große Schichtdicken erzielbar sind. Aber auch die sich anschließenden Bereiche, also die Einspritzöffnung 11 in dem Ventilsitzkörper 17 und der Schaft der Ventilnadel 18 können beschichtet werden.

## Patentansprüche

1. Verwendung einer Hartstoffschicht aus Zirkonoxinitrid mit einer Zirkon, Stickstoff und Sauerstoff enthaltenden, eine kubische Struktur mit einem Elementarzellenparameter a zwischen 0,511 nm und 0,532 nm aufweisenden Phase bei zumindest einem von zwei sich berührenden, relativ zueinander beweglichen Ventilteilen (17, 18) in einem Einspritzventil für den Kraftstoff einer Brennkraftmaschine.

2. Verwendung nach Anspruch 1,
**dadurch gekennzeichnet,**
**dass** bei einem Ventilsitz mit einer Ventilnadel (18) als dem ersten Ventilteil und dem eine durch die Ventilnadel verschließbare Einspritzöffnung (11) aufweisenden zweiten Ventilteil (17) zumindest die Ventilnadel mit der Zirkonoxinitridschicht versehen ist.

3. Verwendung nach Anspruch 2
**dadurch gekennzeichnet,**
**dass** die Einspritzöffnung (11) bildende Wandungen mit der Zirkonoxinitridschicht versehen sind.

## Claims

1. Use of a hard material layer made from zirconium oxynitride with a phase which contains zirconium, nitrogen and oxygen and has a cubic structure with a unit cell parameter a of between 0.511 nm and 0.532 nm for at least one of two valve parts (17, 18), which are in contact with one another and can move relative to one another, in a fuel injection valve of an internal combustion engine.

2. Use according to Claim 1, **characterized in that** if the first valve part is a valve seat with a valve needle (18) and the second valve part (17) has an injection opening (11) which can be closed off by the valve needle, at least the valve needle is provided with the zirconium oxynitride layer.

3. Use according to Claim 2, **characterized in that** walls which form the injection opening (11) are provided with the zirconium oxynitride layer.

## Revendications

1. Utilisation d'une couche de matière dure faite d'oxynitrure de zirconium qui comprend une phase contenant du zirconium, de l'azote et de l'oxygène et présentant une structure cubique ayant un paramètre de cellule élémentaire a compris entre 0,511 nm et 0,532 nm, sur au moins une de deux parties de soupape (17, 18) en contact entre elles et mobiles l'une par rapport à l'autre dans une soupape d'injection pour le carburant d'un moteur à combustion interne .

2. Utilisation selon la revendication 1,
**caractérisée en ce que**, dans une portée de soupape comportant une aiguille de soupape (18) comme première partie de soupape et où la seconde partie de soupape présente une ouverture d'injection qui peut être fermée par l'aiguille de soupape, au moins l'aiguille de soupape est munie d'une couche d'oxynitrure de zirconium

3. Utilisation selon la revendication 2,
**caractérisée en ce que** les parois qui forment l'ouverture d'injection (11) sont munies de la couche d'oxynitrure de zirconium.
